# EUROPEAN PATENT SPECIFICATION

(11) **EP 2 307 895 B1**
(45) Date of publication and mention of the grant of the patent: **14.03.2012**
(21) Application number: 09757872.8
(22) Date of filing: 03.06.2009
(51) Int. Cl.: G01R 31/319, G01R 31/28, H05K 3/32, H05K 3/40, H05K 3/00

(54) **TEST OF ELECTRONIC DEVICES WITH BOARDS WITHOUT SOCKETS BASED ON INDEPENDENT MECHANICAL CLIPPING**
PRÜFUNG ELEKTRONISCHER ANORDNUNGEN MIT LEITERPLATTEN OHNE SOCKEL AUF DER BASIS VON UNABHÄNGIGEM MECHANISCHEM CLIPPEN
TEST DE DISPOSITIFS ÉLECTRONIQUES AVEC DES CARTES DÉPOURVUES DE PRISES FEMELLES, AU MOYEN DE PINCES MÉCANIQUES INDÉPENDANTES

(30) Priority: 03.06.2008 IT MI20081013
(43) Date of publication of application: 13.04.2011
(73) Proprietor: Eles Semiconductor Equipment S.P.A., 06059 Todi (Perugia) (IT)
(72) Inventor: DI LELLO, Stefano, I-06059 TODI (PG) (IT)
(74) Representative: Pezzoli, Ennio
(86) International application number: PCT/IB2009/005877
(87) International publication number: WO 2009/147518

(56) References cited:
- EP-A2- 1 096 549
- JP-A- 2002 309 399
- US-A- 3 596 228
- US-A1- 2005 030 007
- US-A1- 2005 191 123
- US-A1- 2006 171 122

## Description

The solution according to an embodiment of the present invention relates to the field of test. More specifically, such solution relates to the test of electronic devices.

The electronic devices (typically including one or more integrated circuits) are generally subject to a test process in order to verify their correct operation; this is of the utmost importance in order to ensure a high quality of a production process of the electronic devices. The test can be aimed at identifying defects that are evident or potential (that is, that could occur after a short period of use). At the same time, the integrated circuits under test can be conditioned thermally (so as to ensure that they work at a predetermined temperature). A typical example is the burn-in test, which consists of making the electronic devices work for some hours at temperature being very high or very low (for example, from -50°C to +150°C); in this way, it is possible to simulate a long period of the operation of the same electronic devices at room temperature (that is, 25°C-50°C).

The test can be carried out at wafer level or at package level. In the first case, the integrated circuits are tested directly - when they are still included in a wafer of semiconductor material; on the other hand, in the second case the electronic devices are tested after their production is complete (that is, the integrated circuits have been cut and enclosed in suitable packages). The test at package level reduces the risks of damaging of the integrated circuits (for example, due to atmospheric contaminations or hits); moreover, this allows testing the electronic devices in their actual final form.

The test of the electronic devices at package level requires that they should be assembled on test boards, which are used for interfacing the electronic devices with a test apparatus. For such purpose, each test board is equipped with corresponding sockets. The sockets mechanically lock the electronic devices and electrically connect them to the test apparatus; at the same time, the sockets allow removing the electronic devices without any substantial damage at the end of the test process. Typically, each socket is formed by a base that is equipped with elements for electrically contacting input/output terminals of the corresponding electronic device; the base is closed by a cover (for example, being pinned to it), so as to completely enclose the electronic device. In the particular case of test of the thermal type (such as the above-mentioned burn-in test), the test apparatus is also equipped with a system for controlling the temperature of the electronic devices. In general terms, such result is obtained by forcing warm or cold air towards the test boards.

However, each type of socket is specifically designed for a corresponding type of electronic devices (according to their size, shapes, terminal arrangements, and the like). Therefore, the wide range of electronic devices available on the market requires an enormous number of types of sockets. Consequently, there is a proliferation of different components that must be produced individually to be assembled on test boards for testing corresponding types of electronic devices. Such drawback does not allow fully exploiting scale economies in the production of the various sockets; moreover, the wide variety of sockets also causes problems for their warehousing. Therefore, the cost of the sockets remains relatively high, which affects the cost of the best boards and hence also of the whole test process. This-drawback limits the diffusion of the test process, and consequently reduces the level of quality and reliability in the production of the electronic devices.

Moreover, the control of the temperature of the electronic devices is not completely effective. In particular, it is very difficult (if not impossible) to obtain a uniform distribution of the temperature among the various electronic devices.

Alternatively. US-A-2006/171122 proposes the use of spring clips to hold a BGA socket against a substrate provided with holes for receiving these spring clips.
Moreover, EP-A-1095549 discloses a substrate support device with a framework having an aperture supporting an edge of the substrate and a compound spring clip for urging the substrate against the framework.
At the end, US-A-2005/0191123 discloses a method for mounting pins onto a substrate for this purpose, the substrate is provided with an aperture for each pin, wherein the pin is inserted and then moved so as to lock it in a fixed position.

In general terms, the solution according to an embodiment of the present invention is based on the idea of decoupling the mechanical locking of the electronic devices from their electrical contacting.
In particular, various aspects of the solution according to an embodiment of the invention are set out in the independent claims. Advantageous characteristics of the same solution are indicated in the dependent claims.
More specifically, an aspect of the solution according to an embodiment of the invention proposes a test board, according to claim 1, for testing electronic devices (each one of them having a plurality of terminals for electrically contacting the electronic device).

Another aspect of the solution according to an embodiment of the invention proposes a test apparatus, according to claim 11, comprising one or more of such test boards.
A different aspect of the solution according to an embodiment of the invention proposes a production process of the test board, according to claim 12.
The invention, as well as further features and the advantages thereof, will be best understood with reference to the following detailed description, given purely by way of a non-restrictive indication, to be read in conjunction with the accompanying drawings. In this respect, it is expressly intended that the figures are not necessary drawn to scale and that, unless otherwise indicated, they are merely used to conceptually illustrate the structures and procedures described herein. In particular:
FIG.1 is a schematic representation of a test apparatus wherein the solution according to an embodiment of the invention can be used,
FIGs.2A-2B illustrate a portion of test board according to an embodiment of the invention,
FIG.3 is an exploded view of a locking component according to an embodiment of the invention,
FIGs.4A-4D are cross-section views of the same locking component in various operating conditions,
FIGs.5A-5F show the various steps of a process that may be used for producing a test board according to an embodiment of the invention,
FIGs.6A-6B illustrate an application of the solution according to an embodiment of the invention to a different type of electronic devices, and
FIGs.7A-7F show the various steps of a process that may be used for producing a test board according to another embodiment of the invention

With reference in particular to FIG.1, there is shown a schematic representation of a test apparatus 100 wherein the solution according to an embodiment of the invention can be used.

The test apparatus 100 is used for testing electronic devices 105 at package level; for example, the electronic devices 105 are subject to a burn-in test (wherein the electronic devices 105 are tested under thermal stress conditions).

The test apparatus 100 includes a conditioning area 110, which is used for controlling the temperature of the electronic devices 105 during a test process. For this purpose, the electronic devices 105 are placed on test boards 115 (for example, arranged in a matrix with 2-10 rows and 5-20 columns). The test boards 115 are mounted on a pair of tracks 120a and 120b (for their insertion into and removal from the conditioning area 110). Besides, the test apparatus 100 is equipped with a control zone 125, which is maintained at room temperature; the control zone 125 is thermally insulated from the conditioning zone 110, with the two zones 110 and 125 that communicate through slots provided with protecting seals (not shown in the figure). The control zone 125 houses a plurality of driving boards 130. Each test board 115 (once inserted in the conditioning zone 110) is electrically connected to a corresponding driving board 130. The driving board 130 includes the circuits being used for controlling the test process of the electronic devices 105 placed on the test board 115; for example, the driving board 130 provides a power supply and stimulus signals to the electronic devices 105, and receives corresponding result signal from the electronic devices.

At the beginning of the test process, the electronic devices 105 to be tested are provided to a separate assembling station (not shown in the figure), wherein they are mounted on the test boards 115. The test boards 115 (with the electronic devices 105) are then transported to the test apparatus 100 for being inserted into the conditioning area 110 (making them slide on the tracks 120a, 120b). At the end of the test process, the test boards 115 are returned to the assembling station for the removal of the tested electronic devices 105 (with the electronic devices 105 that have passed the test that are then inserted into trays for their final shipping).

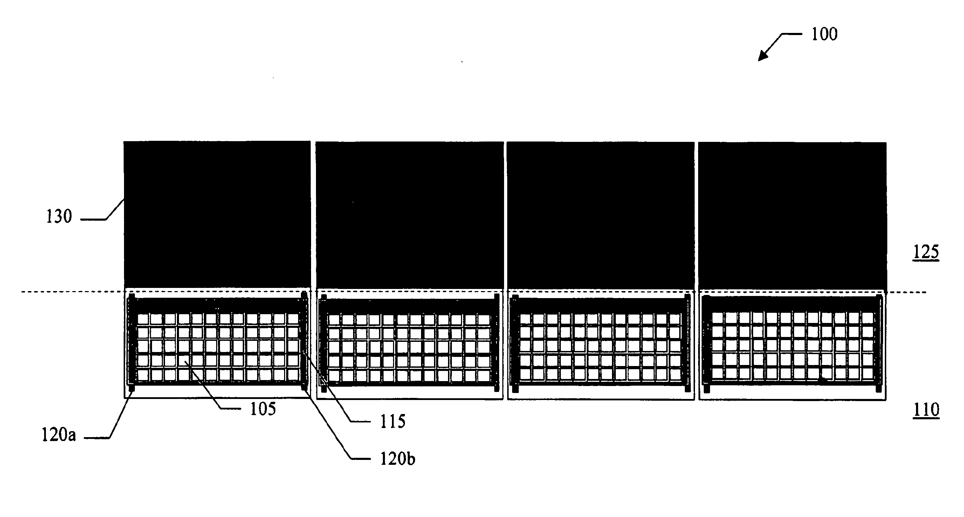

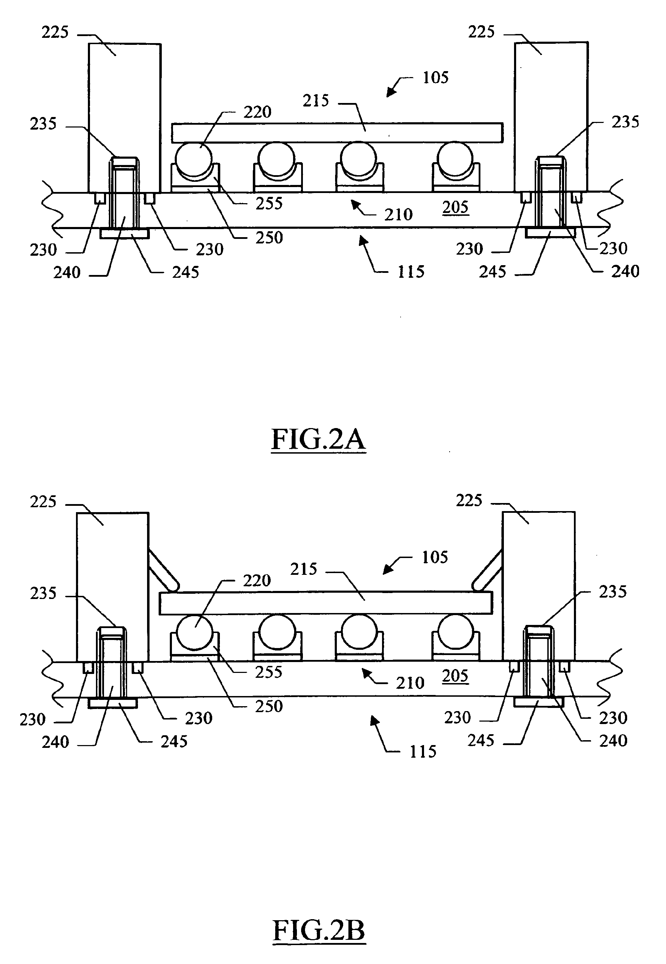

A portion of a generic test board 115 according to an embodiment of the invention is illustrated in detail in FIGs.2A-2B.

In particular, the test board 115 includes a circuited insulating substrate 205 (for example, formed by a printed circuit board with one or more layers of conductive tracks). The test board 115 is equipped with a set of housings 210 (only one shown in figure), each one of them being adapted to receive a corresponding electronic device 105. The electronic device 105 includes an integrated circuit that it is made in a chip of semiconductor material (not shown in figure); the chip is enclosed in a case 215 made up of an insulating body (for example, in plastic material). The chip is electrically connected to external terminals 220 of the electronic device 105, which implement input/output (I/O) functions of the integrated circuit. In the example at issue, the electronic device 105 is of the Ball Grid Array (BGA) type, wherein the terminals 220 consist of a matrix of small spheres projecting from a front (lower) surface of the cover 215. The housing 210 is made up of a bank of conductive elements (connected to the tracks of the substrate 205), each one of them being adapted to electrically contact a corresponding terminal 220. The test board 115 is further equipped with locking components 225 (two in the example at issue), each one of them being used for mechanically locking the electronic device 105 thereon.

More in detail, as shown in FIG.2A, at the beginning of the test process the electronic device 105 is simply rested on the test board 115, with its terminals 220 that are received by the corresponding conductive elements of the housing 210. Passing to FIG.2B, the locking components 225 are actuated (for example, by lowering a lever mechanism), so as to press the electronic device 105 against the test board 115 (and in particular the terminals 220 into the conductive elements of the housing 210). Consequently, the electronic device 105 is mechanically locked on the test board 115; at the same time, this ensures a correct electrical connection of the terminals 220 with the conductive elements of the housing 210. At the end of the test process (FIG.2A), the locking components 225 are de-actuated (by raising the lever mechanism), so as to free the electronic device 105; the electronic device 105 can hence be removed from the test board 115 without any damage

In the solution according to an embodiment of the present invention, as described in detail in the following, the locking components 225 are assembled on the substrate 205 in an independent way from the conductive elements of the housing 210.

For example, in the embodiment illustrated in the figure, centring pegs 230 project downwards from a base surface of each locking component 225. The centring pegs 230 are inserted into corresponding blind holes of the substrate 205 for correctly positioning the locking components 225 (with respect to the corresponding housing 210). On the base surface of the locking components 225 there are further made blind threaded holes 235 (only one shown in the figure) Each threaded hole 235 is aligned with a through smooth hole 240 that crosses the substrate 205. A tap screw 245 is inserted from below the substrate 205 into each smooth hole 240, and is hence screwed into the corresponding threaded hole 235 (thereby pulling the locking component 225 against the substrate 205).

In such way, the test boards 115 can be customized for the various types of electronic devices 105 by consequently designing the housings 210 only (according to the size and shape of the package 215, and to the arrangement of the terminals 220). A single type of locking components 225 can instead be used on all the test boards 115 (independently of the type of electronic devices 105 to be tested). Therefore, the locking component 225 becomes a universal element for all the test boards 115. This allows exploiting scale economies in the production of the locking components 225; moreover, this also simplifies the respective warehousing. Therefore, the cost of the locking components 225 is remarkably reduced, with a positive repercussion on the cost of the test boards 115 and therefore of the whole test process. Such advantages foster the diffusion of the test process, with positive falling back on the quality and reliability of the production of the electronic devices 105.

In the particular case of tests of the thermal type (such as the burn-in test at issue), warm or cold air is forced towards the test boards 115 in order to thermally condition (that is, to heat or to cool, respectively) the electronic devices 105 under test. In such case, the locking components 225 practically do not affect the circulation of the cold/warm air, which can thus directly act on the electronic devices 105 (no more enclosed in any socket). This allows controlling the temperature of the electronic devices 105 in a more effective way. In particular, the direct action of cold/warm air on the electronic devices 105 makes it possible to obtain a substantially uniform distribution of the temperature among them.

In an embodiment of the proposed solution, the conductive elements of each housing 210 are preferably formed directly on the substrate 205 (independently to each other). For example, each conductive element includes an (electrically conductive) pad 250, which is electrically connected to the tracks of the substrate 205 - with the pads 250 that are arranged according to the terminals 220 (that is, in a matrix in the case at issue of electronic device 105 of the BGA type); an (electrically conductive) receptacle 255 is then formed on each pad 250. In such way, it is possible to reduce the assembling operations being required for the production of the test boards 115 to the minimum (that is, only those for the assembly of the locking components 225).

In the case at issue, the receptacles 255 are concave-shaped; moreover, the receptacles 255 are preferably resilient (that is, they elastically deform under the pressure exerted by the electronic device 105). Consequently, it is possible to obtain a self-centring of the (convex) terminals 220 in the receptacles 255. This simplifies the positioning of the electronic devices 105 on the test board 115; moreover, it is possible to prevent any misalignment of the electronic devices 105 in respect of the test board 115 (for example, during its moving).

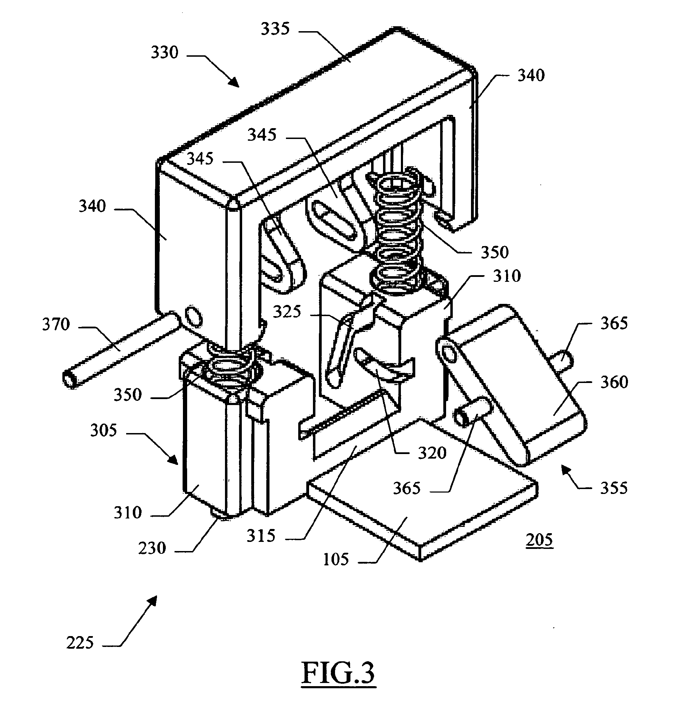

Passing now to FIG.3, there is shown an exploded view of a generic locking component 225 according to an embodiment of the invention.

The locking component 225 is made up of a rest base 305 - whence the centring pegs 230 project and on whose lower surface there are made the threaded holes (not shown in figure) for the assembly of the base 305 on the substrate 205. The base 305 includes two turrets 310, which are joined to each other (on a front surface facing the housing for the electronic device 105) through a lower crosspiece 315. Two longitudinal grooves are formed in correspondence of the external corners of each turret 310, so as to define a vertical guide; each groove ends at the top with a corresponding stop tooth. On an internal surface of each turret 310, there are further made a front groove 320 (opened on the front surface of the turret 310), which extends along a generically curved line, and a rear groove 325 (opened on an upper surface of the turret 310), which extends along a line with an (active) straight lower portion and a mounting S-shaped upper portion

The base 305 is surmounted by a sledge 330. The sledge 330 is made up of a cover 335 whence two lateral wings 340 extend downwards. A longitudinal groove is formed at the centre of an internal surface of each wing 340, so as to define a cursor matching the guide of the corresponding turret 310; the groove is delimited by two sidewalls, each one of them ending with a hook being suitable to interfere with the corresponding stop tooth of the turret 310. Two stirrups 345 are made under the cover 335; in particular, each stirrup 345 includes a hanging plate from a lower surface of the cover 335, in which there is made a slotted hole that extends along a substantially horizontal line. Two springs 350 are arranged between the base 305 and the sledges 330; more specifically, each spring 350 abuts at the bottom in a seat being made on the lower surface of a corresponding turret 310, and to the opposite end it abuts at the top in another seat being made on the lower surface of cover 335.

The locking component 225 also comprises a lever 355. The lever 355 is made up of a plate 360, which has a width being slightly lower than a distance between the stirrups 345 and a length being slightly lower than an extension in diagonal of the turrets 310. Two pins 365 project laterally (in opposite direction) at the centre of plate 360; each pin 365 is inserted in the facing groove 320 (through its front opening). A through hole extends transversely from an inner end of plate 360. A peg 370 (slightly longer than the distance between the turrets 310) is inserted in the slotted hole of a stirrup 345, in the trough hole of the plate 360, and hence in the slotted hole of the other stirrup 345; each end of the peg 370 (projecting from the corresponding stirrup 345) is then inserted into the groove 325 (through its upper opening and its S-shaped portion).

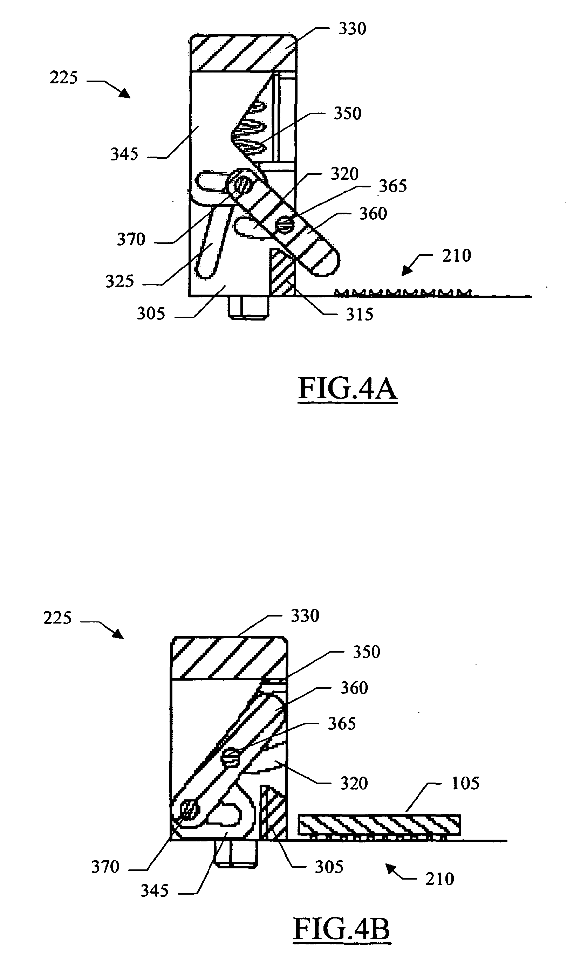

With reference to FIGs.4A-4D, there are instead shown cross-section views of the same locking component 225 in different operating conditions.

Beginning from FIG.4A, in a free condition (in which no external action is applied to the locking component 225), the springs 350 remove the sledge 330 from the base 305; therefore, the sledge 330 raises until its hooks reach the stop tooth of the base 305 (whose interference prevents the upper slipping off of the sledge 330). At the same time, the stirrups 345 drag the peg 370 upwards (by making it slide along the straight portion of the groove 325), so as to raise the inner end of the plate 360. Consequently, the external end of the same plate 360 is lowered (with the pins 365 that slide towards the outside of the grooves 320), until they abut against the crosspiece 315. In this condition, the plate 360 maintains at a prefixed distance from the corresponding housing 210 (for example, 0.5-1.0 mm) so as to avoid any damaging of its conductive elements in the absence of electronic devices to be tested.

Passing to the FIG.4B, the locking component 225 is brought to an inactive condition by applying a pressure on the sledge 330 - for example, by a Burn-in Loader Unloader (BLU) of the assembly station (not shown in the figure). In such way, the sledge 330 lowers towards the base 305 in opposition to the springs 350 (which elastically compress); for example, the springs 350 are sized so as to obtain their elastic yielding with a force of the order of 10-20N. At the same time, the stirrups 345 drag the peg 370 downwards (making it slide along the straight portions of the corresponding grooves, not visible in the figure), so as to lower the inner end of the plate 360 (with the pins 365 that slide towards the inside of the grooves 320). Consequently, the external end of the same plate 360 rises until completely enter inside the base 305. In this condition, the plate 360 does not interfere in any way with the electronic device 105, which can be freely rested on the housing 210 (at the beginning of the test process) and removed from the same (at the end of the test process).

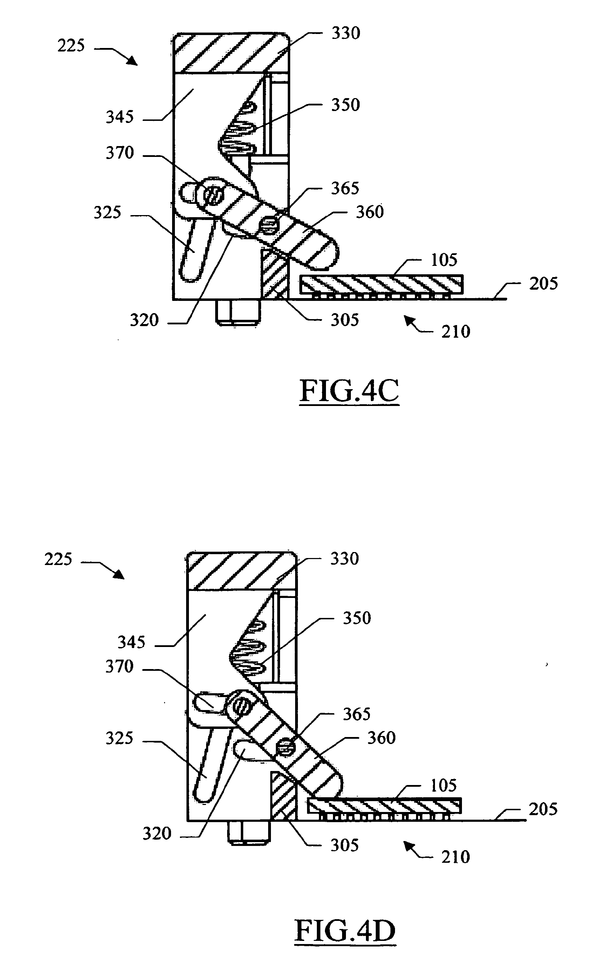

As soon as the pressure on the sledge 330 is removed, as shown in FIG.4C, the springs 350 return towards their extended condition thereby raising the sledge 330 while moving away from the base 305. At the same time, the stirrups 345 drag the peg 370 upwards (making it slide along the straight portions of the corresponding grooves 325), so as to raise the inner end of the plate 360 (with the pins 365 that slide towards the outside of the grooves 320). Consequently, the external end of the same plate 360 is lowered towards the electronic device 105 rested on the housing 210. In such phase, the plate 360 is at any moment subject in general terms to a roto-traslation motion (with a component of rotation around a centre of instantaneous rotation and a component of translation). In an embodiment of the invention, when the free end of the plate 360 has reached a threshold distance from the substrate 205, its centre of instantaneous rotation is substantially found at the same distance from the substrate 205; the threshold distance (for example, 1,5-2,0 millimetre) is chosen so as to be higher than the encumbrance (over the substrate 205) of the different types of electronic devices 105 that can be rested on the housing 210.

Considering now FIG.4D, the sledge 330 continues raising (moving away from the base 305) until the free end of the plate 360 reaches the electronic device 105 (before the springs 350 are completely extended).

In such phase, the centre of instantaneous rotation of the plate 360 lowers so as to maintain always at the same distance from the substrate 205 as the free end of the plate 360. Therefore, when the plate 360 contacts the electronic device 105 their relative motion has a substantially null horizontal component. Such expedient avoids any push on the electronic device 105 that could misalign it in respect to the housing 210.

At this point, the elastic force exerted by the springs 350 presses the free end of the plate 360 against the electronic device 105. In particular, the plate 360 acts as a lever of the first order (with a fulcrum defmed by its centre of instantaneous rotation), in which the force applied by the springs 350 to the inner end of the plate 360 is transferred to the electronic device 105 by the free end of the plate 360 - multiplied by a yield of the lever defined by the ratio between its power arm (from the inner end of the plate 360 to the fulcrum) and its resistance arm (from the free end of the plate 360 to the fulcrum). As a further improvement, the centre of instantaneous rotation (in addition to lowering) also moves towards the free end of the plate 360 (for example, along a slanted straight line). In such way, the yield of the lever increases (since the power arm extends and the resistance arm shortens). Therefore, it is possible to compensate a decrease of the elastic force of the springs 350 with the increasing of their extension - so as to obtain the application of a substantially constant force by the free end of the plate 360 at different distance from the substrate 205; for example, a structure of the springs 350 and a law of motion of the centre of instantaneous rotation are defined so as to obtain a force of the order of 5-15N on the electronic device 105 for any encumbrance of the same above the substrate 205 until the threshold distance (for example, between 1.0 mm and 1.6 mm).

Preferably, the locking components 225 are used in pair (arranged at opposite positions with respect to the electronic device 105); in general terms, a single pair of locking components 225 is sufficient for the electronic devices 105 of standards size. In this way, the locking components 225 of the pair act on opposite edges of the electronic device 105. This allows obtaining an optimal mechanical locking of the electronic device 105 with a sufficiently uniform distribution of the force applied on the same one.

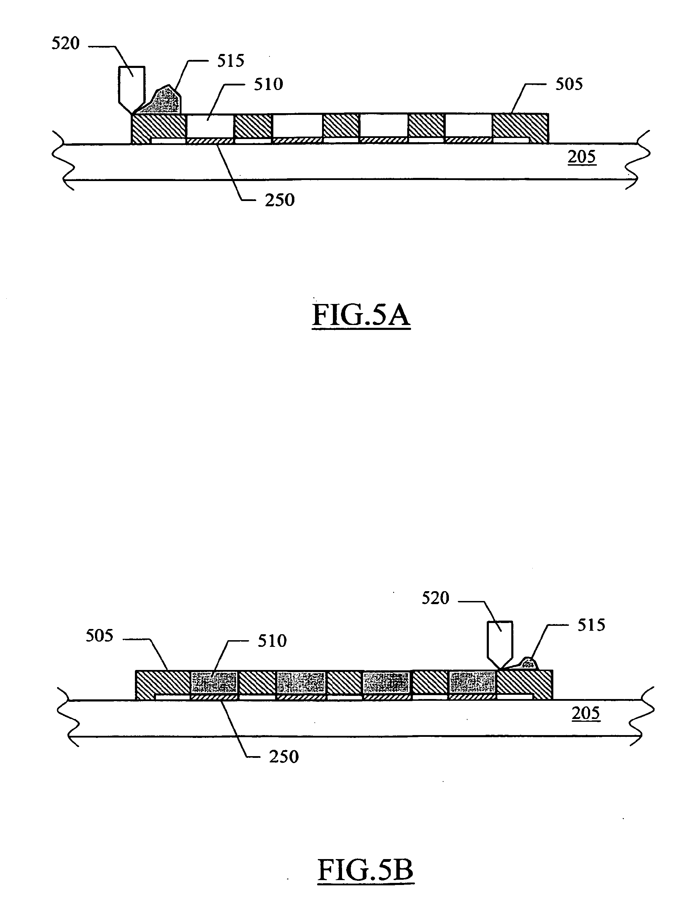

The various steps of a process that can be used for producing the test board according to an embodiment of the invention is shown in FIGs.5A-5F.

Considering in particular FIG.5A, the process starts by providing the substrate 205; the pads 250 are made on the upper surface of the substrate 205 - in the positions corresponding to the terminals of the electronic devices to be tested - by conventional photolithography techniques (for example, depositing an aluminium layer that is then selectively etched).

A precursor material of the receptacles is distributed on the pads 250 by a silk-screening technique. For this purpose, a stencil 505 is rested on the substrate 205. The stencil 505 includes a matrix of windows 510 corresponding to the pads 250. A polymer 515 is then applied on the pads 250 - through the stencil 505 - by a blade 520; the polymer 515 consists of a material that is electrically conductive and deformable (for example, the commercial product "Loctite 3880" distributed by Loctite Corp.).

As shown in FIG.5B, this result is obtained by making the blade 520 cross the whole stencil 505; in such way, the polymer 515 is pushed inside the windows 510.

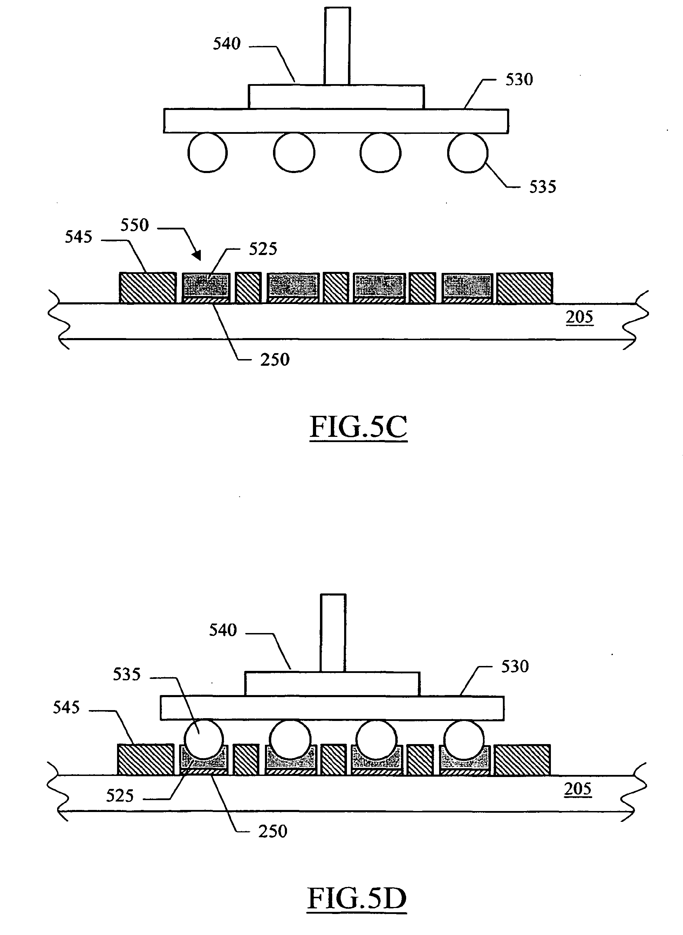

Passing to FIG.5C, when the stencil is removed an island of polymer 525 remains on each pad 250. The islands 525 are then shaped - according to the terminals of the electronic devices to be tested - by a forming tool 530. For this purpose, a bottom surface of the forming tool 530 is equipped with a matrix of dummy elements 535 that mimic the terminals of one or more electronic devices; the forming tool 530 may consist of a dummy component or of one or more samples of the electronic devices. The forming tool 530 is assembled on a pick and place head 540; the head 540 is controlled by an optical system, such as a laser or infrared system (not shown in figure), which allows correctly aligning the dummy elements 535 with the islands 525.

Preferably, a restraining stencil 545 is also arranged on the substrate 205. The stencil 545 includes a matrix of windows 550 corresponding to the islands 525. Each window 550 has the same shape of the corresponding island 525, but it is slightly wider. In this way, an empty channel is formed around the island 525 (between it and the stencil 545); for example, this channel has a width that vary preferably between 50 µm - 250µm, and more preferably between 100µm - 200µm, such as 150µm.

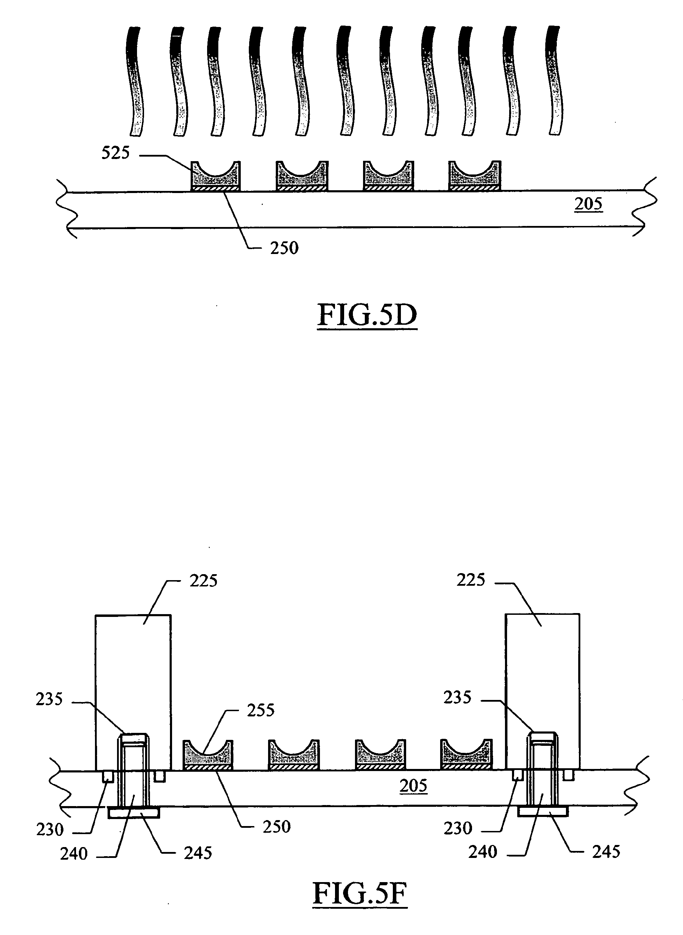

At this point, the head 540 is lowered so as to press the forming tool 530 against the substrate 205 (see FIG.5D). Consequently, the dummy elements 535 act as a mould that deforms the islands 525 accordingly; the islands 525 are therefore shaped like a negative of the dummy elements 535 (and therefore of the terminals of the electronic devices). The same operation is repeated (if necessary) till all the islands 525 of the test board have been shaped.

In this phase, the pressure that is exercised by each dummy element 535 on the corresponding island 525 can also widen it. However, the island 525 can expand at most of the width of the channel that is formed around it by the stencil 545. In this way, the stencil 545 limits the extension of the widening of the islands 525. This prevents that adjacent islands 525 can enter in contact (thereby creating short circuits that would impair the operation of the resulting test board). Besides, in this way it is possible to use any wished material to make the islands 525 (for example, with a very high conductivity), even if it is too much fluid.

Passing to FIG.5E, the head is raised and the forming tool is removed (together with the control stencil, if present). The structure thus obtained is now inserted into a furnace (for example, at 125-200°C for 10-30 min.), so as to polymerise the material that forms the (shaped) islands 525.

In this way, as shown in FIG.5F, the islands are hardened in order to form the wished receptacles 255. The production of the test board is completed by assembling the locking components 225 - positioned through the centring pegs 230, and therefore fastened by the screws 245 (that are inserted into the smooth holes 240 and screwed into the threaded holes 235).

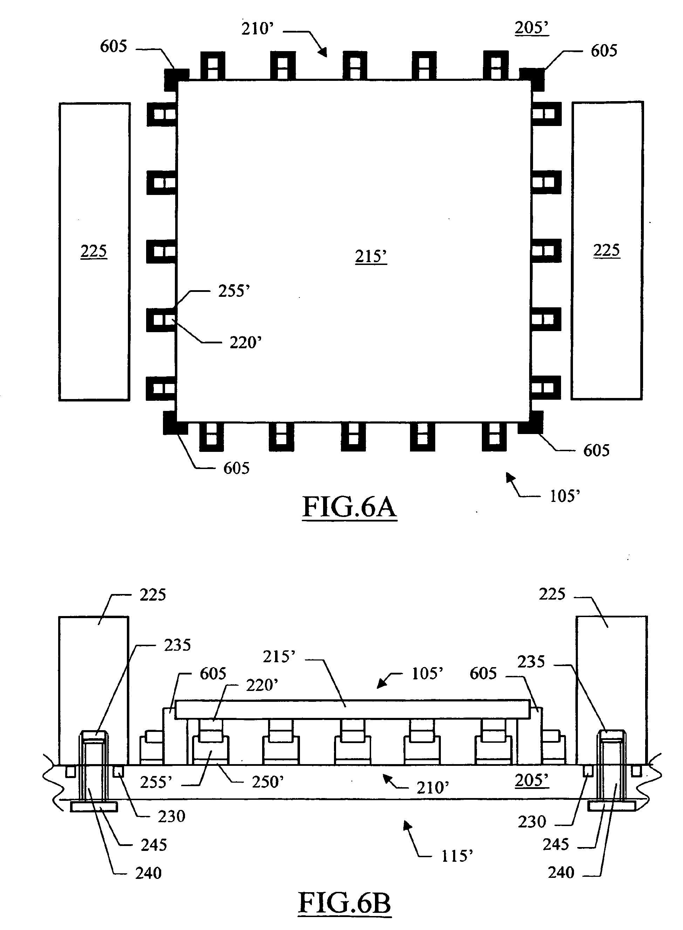

The application of the solution according to an embodiment of the invention to a different type of electronic devices is illustrated in FIGs.6A-6B (in the following, the elements corresponding to those shown in the previous figures will be differentiated with an apex). In particular, the figures show a generic electronic device 105' of the Quad Flat Package (QFP) type. In this case, the electronic device 105' has a cover 215' with terminals 220' extending from each one of its four edges; the terminals 220' are of the gull wing type (that is, consisting of conductors that extend horizontally, being folded downwards and therefore towards the outside so as to define a plane contact for the surface assembly of the electronic device 105').

A test board 115' is again formed by a circuited insulating substrate 205' with a housing 210' for each electronic device 105' to be tested. The housing 210' consists of a bank of conductive elements for electrically contacting the terminals 220' of the electronic device 105'; each conductive element includes a pad 250' on which a receptacle 255' is formed for receiving the corresponding terminals 220'. In this case, each receptacle 255' includes a print matching the plane contact of the terminal 220'. Preferably, four centring turrets 605 are further formed on the upper surface of the substrate 205'. The centring turrets 605 are higher than the receptacles 255' are, so as to reach the cover 215' (when the terminals 220' are rested on the receptacle 255'). The centring turrets 605 are arranged at the four corners of the cover 215 '; each centring turret 605 has an inner depression for receiving a corresponding edge of the covering 215'. The centring turrets 605 facilitate the positioning of the electronic device 105' on the test board 115' and prevent any misalignment between them (also in this case wherein the terminals 220' are not self centring). As mentioned above, the electronic device 105' is mechanically locked on the test board 115' by the same pair of locking components 225.

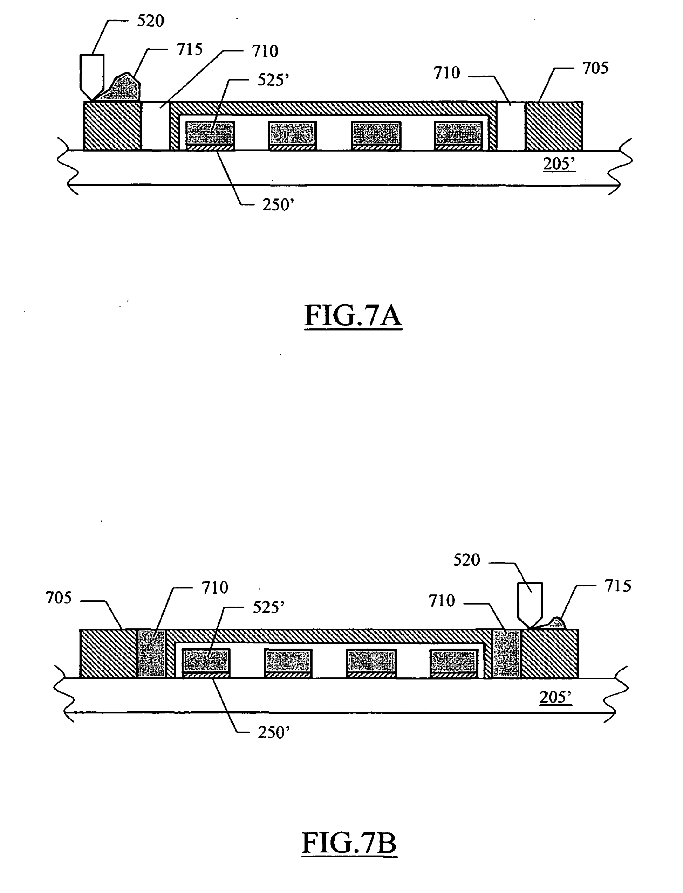

The various steps of a process that may be used for producing the above-described test board are illustrated in FIGs.7A-7F.

Considering in particular FIG.7A, the same operations previously described are repeated in order to form the pads 250' on the upper surface of substrate 205', and then the islands 525' on the pads 250'. A further silk-screening operation is executed in order to distribute a precursor material of the centring turrets on the substrate 205'. For this purpose, a stencil 705 is arranged on the substrate 205'. The stencil 705 is thicker than that used for creating the islands 525', and it is equipped with legs for spacing it from the islands 525' (so as to avoid their damaging); the stencil 705 includes four windows 710 at the corner of the matrix of pads 250' (only two shown in the figure). A polymer 715 is then applied on the substrate 205' - through the stencil 705 by a blade 520; the polymer 715 consists of a conductive or insulating deformable material (for example, the same one used to form the islands 525').

As above, see FIG.7B, this result is obtained by making the bade 520 cross the whole stencil 705; in such way, the polymer 715 is pushed inside the windows 710.

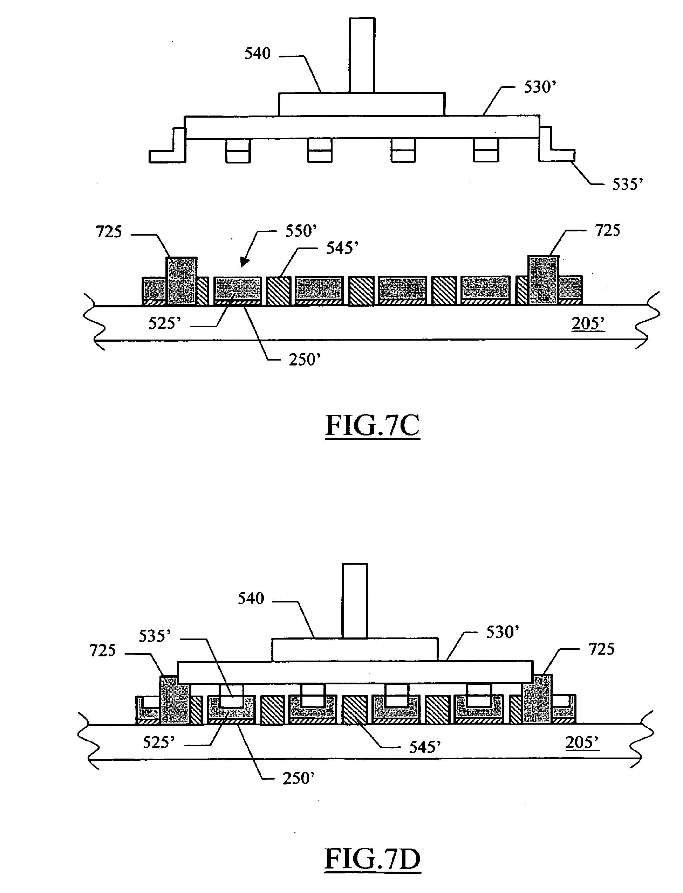

Passing to FIG.7C, when the stencil is removed four columns 725 of polymer (only two shown in figure) remain on the substrate 205'. The islands 525' and the columns 725 are then shaped - according to the electronic devices to be tested - by a forming tool 530'. The forming tool 530' has a main body corresponding to the case of an electronic device (or more); dummy elements 535' extend from each one of the four edges of the main body of the forming tool 530', so as to mimic the terminals of the electronic devices. The forming tool 530' is assembled on the same head 540 as above. In this case as well, a restraining stencil 545' (with windows 550' being slightly wider than the islands 525') can be placed on the substrate 205'.

At this point, the head 540 is lowered so as to press the forming tool 530' against the substrate 205' (see FIG.7D). Consequently, the dummy elements 535' act as a mould that deform the islands 525' accordingly (by shaping them like negative of the dummy elements 535' and then of the terminals of the electronic devices); as above, the stencil 545' limits the widening of the islands 525'. At the same time, each edge of the main body of the forming tool 530' prints an inner portion of the corresponding column 725.

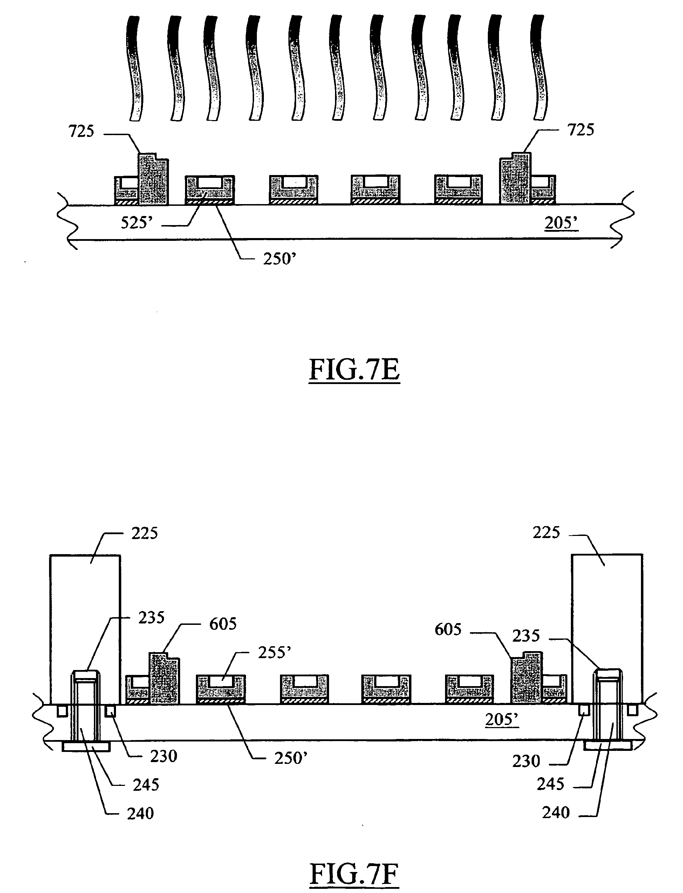

Passing to FIG.7E, the head is raised and the forming tool is removed (with the restraining stencil, if present). The structure thus obtained is again inserted into a furnace, so as to polymerise the material that form the (shaped) islands 525' and columns 725. In this way, as shown in FIG.7F, the islands and the columns are hardened in order to form the desired receptacles 255' and centring turrets 605, respectively. As above, the production of the test board is then completed by assembling the locking components 225.

Naturally, in order to satisfy local and specific requirements, a person skilled in the art may apply to the solution described above many logical and/or physical modifications and alterations. More specifically, although this solution has been described with a certain degree of particularity with reference to preferred embodiment(s) thereof, it should be understood that various omissions, substitutions and changes in the form and details as well as other embodiments are possible. Particularly, the same solution may even be practiced without the specific details (such as the numerical examples) set forth in the preceding description to provide a more thorough understanding thereof; conversely, well-known features may have been omitted or simplified in order not to obscure the description with unnecessary particulars. Moreover, it is expressly intended that specific elements and/or method steps described in connection with any embodiment of the disclosed solution may be incorporated in any other embodiment as a matter of general design choice.

In particular, analogous considerations apply if the test board has a different structure or includes equivalent elements; in any case, the test board can be provided with any number of housings for corresponding electronic devices to be tested. More generally, the same test board can be used in any test process in the widest meaning of the term (even not of the thermal type); for example, it is possible to use such solution in reliability tests during a preliminary phase of development of the electronic devices (in order to verify small series of electronic devices, down to those being housed on a single test board); other examples are functional tests or parametric tests (that may be also executed at the same time of the burn-in test). Moreover, as previously described, it is possible to test the electronic devices in electrical and/or thermal stress conditions (for example, forcing specific thermal cycles); alternatively, it is possible to simply maintain the temperature of the electronic devices under test at a predetermined value (for example, at room temperature). Moreover, the proposed solution lends itself to be applied to any type of electronic devices (for example, of optical type, based on discreet components, and so on). Moreover, the electronic devices can be provided in different packages (for example, of the Dual-In-Line type), or can have equivalent terminals (for example, of J-shaped type).

The above-described technique of assembly the locking components on the substrate of the test board is purely indicative, and it does not have to be interpreted in a restrictive sense; in fact, the proposed solution can be implemented with any other means for assembling the locking components independently from the receptacles (for example, of the clip type, of the welding type, and the like).

In principle, is not excluded even the possibility of making the housings separately on corresponding supports that are then mounted on the substrate.

Analogous considerations apply if the locking components have a different structure or include equivalent elements (or they are replaced by other means being suitable to perform the same function).

In alternative, it is possible to use a different number of locking components for each electronic device (for example, one for each edge of its case); in any case, in some applications it is also feasible to use a single locking component acting at the centre of the electronic device.

Alternatives embodiments of the proposed solution can be obtained with equivalent elements for acting on the electronic device to be locked on the test board - for example, a clip.

Nothing prevents, however, making the lever in a different way, or replacing it with another element (such as a springlet).

The threshold distance from the substrate (beyond which the centre of instantaneous rotation of the lever is found at the same height as its free end) can take other values.

Moreover, the centre of instantaneous rotation can move towards the free end of the lever along a different line (for example, a hyperbolic one); in any case, the possibility of moving the centre of instantaneous rotation vertically (or also maintaining it fixed) is not excluded.

In a different embodiment, the lever can be constrained only at the rest base (with the sledge that controls its rotation).

In alternative, the lever can be simply pinned to the sledge.

In any case, it is possible to obtain the desired law of motion for the lever with any other kinematics.

The above-described conformations of the guides (for the pins and the peg of the lever) are purely illustrative, and they do not have to be interpreted in a limiting way; for example, nothing prevents having all the guides extending along curve lines, only some of them, or no one.

The proposed solution can also be implemented with a structure of the locking component that requires two distinct active commands in order to switch both to the active condition and to the inactive condition (without any biasing means).

In any case, the biasing of the lever can be made with other equivalent means (even being not elastic).

For example, it is possible to provide a torsion spring that directly acts on the lever.

Analogous considerations apply if the end of stoke of the lever (for preventing it to reach the receptacles) is obtained in an equivalent way - for example, directly through the corresponding guides.

The proposed solution lends itself to be implemented with equivalents receptacles for receiving the terminals of the electronic devices (also simple pads), being made in any other material (even being not elastic).

Each electronic device can be aligned with respect to the corresponding receptacle by one or more equivalent centring elements (for example, a frame). Moreover, nothing prevents applying the same solution also to the test board with the concave receptacles; vice-versa, the removal of the centring turrets from the test board with the plan receptacles is contemplated.

Similar considerations apply if the test system has a different architecture or includes similar components. In any case, the test system can receive a different number of test boards (down to a single one).

In alternative, the test board can be produced with an equivalent process (by using similar steps, removing some steps being not essential, or adding further optional steps - also in a different order).

For example, it is possible to use any other material that is deformable and electrically conductive to form the receptacles (such as another epoxy resin), the polymer can be shaped and hardened in a different way (for example, by a moulding technique), or the islands on the pads can be formed with another technique (for example, depositing a layer of polymer and then etching it selectively).

The channels defined around the islands by the restraining stencil can have a different width; moreover, the same result can be achieved with other equivalent means, also intended to remain on the test board (for example, a net, insulating bushes, and the like). In any case, this step can also be completely omitted (such as when the material used to form the islands is very viscous, or the islands are sufficiently spaced apart to each other).

The same observations above apply to the operations required to form the centring turrets.

## Claims

1. A test board (115;115') for testing electronic devices (105;105') each one having a plurality of terminals (220;220') for electrically contacting the electronic device, wherein the test board includes:
a support substrate (205;205'),
a set of banks of electrically conductive receptacles (210;210') being arranged on the substrate each one for resting a corresponding electronic device, each receptacle (250,255;250',255') being adapted to receive a terminal of the corresponding electronic device,
locking means (225) being arranged on the substrate for mechanically locking the electronic devices on the test board, for each bank of receptacles the locking means including at least one locking component (225) for pressing the electronic device rested on the bank of receptacles against the bank of receptacles, and
assembly means (230-245) for assembling the locking means on the substrate independently of the receptacle,
**characterized in that**
each locking component (225) includes a main body (305,330) being assembled on the substrate (205;205') by the assembly means (230-245), a push element (355) coupled with the main body, and switching means (350) for switching the push element between an active position in which it presses the electronic device (105;105') against the bank of receptacles (210;210') and an inactive position in which it does not interfere with the electronic device.

2. The test board (115;115') according to claim 1, wherein the push element (355) includes a lever (355) ending with a free end for acting on the electronic device (105;105'), and wherein the locking component (225) further includes coupling means (320,365,325,370) for coupling the lever with the main body (305,330), the coupling means (320,365,325,370) being adapted to rotate the lever (355) around a centre of instantaneous rotation, in at least one final portion of the switching towards the active position the centre of instantaneous rotation and the free end of the lever being substantially at a same distance from the substrate (205;205').

3. The test board (115;115*')* according to claim 2, wherein at least in the final portion of the switching towards the active position the coupling means (320,365,325,370) are adapted to move the centre of instantaneous rotation towards the free end of the lever (355).

4. The test board (115;115') according to claim 1 or 2, wherein the main body (305,330) includes a rest base (305) being assembled on the substrate (205;205') by the assembly means (230-245) and a sledge (330) sliding with respect to the base along a direction being substantially perpendicular to the substrate, the coupling means (320,365,325,370) being adapted to couple the lever (355) at least in rotation to the sledge and in roto-translation to the base.

5. The test board (115;115') according to claim 4, wherein the coupling means (320,365,325,370) are adapted to couple the lever (355) in roto-translation to the sledge (330), the coupling means (320,365,325,3,70) including a first guide (320) and a second guide (325) on the base (305), a third guide (345) on the sledge (330), first pin means (365) and second pin means (370) on the lever (355), the first pin means sliding along the first guide, and the second pin means sliding along the second and the third guide.

6. The test board (115;115') according to claim 5, wherein at least one among the first guide (320), the second guide (325) and the third guide (345) extends along a curved line.

7. The test board (115;115') according to any claim from 1 to 6, wherein the switching means (350) include biasing means (350) for biasing the push element (355) towards the active position, the push element being brought to the inactive position in response to an external command in opposition to the biasing means.

8. The test board (115,115') according to any claim from 1 to 7, wherein each locking component (225) further includes stopping means (315) for preventing the push element (355) to reach the bank of receptacles (210;210') in absence of the electronic device (105:105').

9. The test board (115) according to any claim from 1 to 8, wherein each terminal (220) ends with a convex contact region, each receptacle (250,255) including a concave recess matching the convex contact region of the corresponding terminal and being made of an elastic material adapted to be elastically deformed in response to a pressure of the electronic devices (105) against the test board (115).

10. The test board (115') according to any claim from 1 to 9, wherein each test board further includes centring means (605) for each bank of receptacles (210'), the centring means being adapted to interfere with the corresponding electronic device (105') for aligning each terminal (220') of the electronic device with the corresponding receptacle (250',255').

11. A test apparatus (100) including a set of test boards (115;115') according to any claim from 1 to 10, and means (130) for testing the electronic devices (105;105') rested on the test board.

12. A production process of a test board (115:115') for testing electronic devices (105:105') each one having a plurality of terminals (220;220') for electrically contacting the electronic device, wherein the production process includes the steps of:
providing a support substrate (205;205'),
arranging a set of banks of electrically conductive receptacles (210;210') on the substrate each one for resting a corresponding electronic device, each receptacle (250,255;250',255') being adapted to receive a terminal of the corresponding electronic device, and
mounting locking means (225) on the substrate independently of the receptacles for mechanically locking the electronic devices on the test board, for each bank of receptacles the locking means including at least one locking component (225) for pressing the electronic device rested on the bank of receptacles against the bank of receptacles,
**characterized in that**
the step of mounting includes:
mounting a main body (305,330) of each locking component (225) on the substrate (205;205'), the locking component further including a push element (355) coupled with the main body, and switching means (350) for switching the push element between an active position in which it presses the electronic device (105;105') against the bank of receptacles (210;210') and an inactive position in which it does not interfere with the electronic device.

13. The production process according to claim 12, further including the steps of:
making a bank of islands (525;525') for each bank of receptacles on the substrate (205;205'), the islands being made of an electrically conductive and deformable material,
pressing a forming tool (530;530') including a plurality of forming elements (535;535') corresponding to the terminals of at least one electronic device against the islands to deform the islands according to the forming elements, and
hardening the islands for obtaining the corresponding receptacles.

14. The production process according to claim 13, further including the steps of:
arranging restraining means (545;545') around each island (525;525') for limiting a widening of the islands during the step of pressing the forming tool (530;530').

15. The production process according to claim 13 or 14, further including the steps of:
forming at least one column (725) of further deformable material for each bank of receptacles on the substrate (205'), the at least one column being pressed in an inner portion by an edge of a main body of the forming tool (530') corresponding to a package of at least one electronic device, and
hardening the at least one column for obtaining corresponding centring means being adapted to interfere with the corresponding electronic device (105') for aligning each terminal (220') of the electronic device with the corresponding receptacle (250',255').

## Patentansprüche

1. Prüfplatine (115; 115') zum Prüfen elektronischer Bauteile (105; 105'), wobei jede eine Mehrzahl von Anschlüssen (220; 220') für ein elektrisches Kontaktieren des elektronischen Bauteils aufweist, wobei die Prüfplatine beinhaltet:
ein Trägersubstrat (205; 205'),
einen Satz von Bänken elektrisch leitender Aufnahmeeinrichtungen (210; 210'), die auf dem Substrat angeordnet sind, wobei eine jede dazu dient, dass auf ihr ein entsprechendes elektronisches Bauteil ruht, wobei jede Aufnahmeeinrichtung (250, 255; 250', 255') ausgebildet ist, um einen Anschluss des entsprechenden elektronischen Bauteils aufzunehmen,
eine Verriegelungseinrichtung (225), die auf dem Substrat angeordnet ist, um die elektronischen Bauteile auf der Prüfplatine mechanisch zu verriegeln, wobei für jede Bank von Aufnahmeeinrichtungen die Verriegelungseinrichtung mindestens ein Verriegelungsbauteil (225) beinhaltet, um das elektronische Bauteil, das auf der Bank von Aufnahmeeinrichtungen ruht, gegen die Bank von Aufnahmeeinrichtungen zu drücken, und
eine Montageeinrichtung (230-245), um die Verriegelungseinrichtung auf dem Substrat unabhängig von der Aufnahmeeinrichtung zu montieren,
**dadurch gekennzeichnet, dass**
jedes Verriegelungsbauteil (225) einen Hauptkörper (305, 330), der auf dem Substrat (205; 205') durch die Montageeinrichtung (230-245) montiert ist, ein Drückelement (355), das mit dem Hauptkörper verbunden ist, und eine Umschalteinrichtung (350) beinhaltet, um das Drückelement zwischen einer aktiven Position, in der es das elektronische Bauteil (105; 105') gegen die Bank von Aufnahmeeinrichtungen (210; 210') drückt, und einer inaktiven Position umzuschalten, in der es nicht auf das elektronische Bauteil einwirkt.

2. Prüfplatine (115; 115') nach Anspruch 1, wobei das Drückelement (355) einen Hebel (355) beinhaltet, der in einem freien Ende zum Einwirken auf das elektronische Bauteil (105; 105') endet, und wobei das Verriegelungsbauteil (225) weiter eine Kopplungseinrichtung (320, 365, 325, 370) beinhaltet, um den Hebel mit dem Hauptkörper (305, 330) zu koppeln, wobei die Kopplungseinrichtung (320, 365, 325, 370) ausgebildet ist, um den Hebel (355) um einen momentanen Rotationsmittelpunkt zu rotieren, wobei in mindestens einem Endabschnitt des Umschaltens zur aktiven Position der momentane Rotationsmittelpunkt und das freie Ende des Hebels sich im Wesentlichen in der gleichen Entfernung vom Substrat (205; 205') befinden.

3. Prüfplatine (115; 115') nach Anspruch 2, wobei zumindest im Endabschnitt des Umschaltens hin zur aktiven Position die Kopplungseinrichtung (320, 365, 325, 370) ausgebildet ist, um den momentanen Rotationsmittelpunkt hin zum freien Ende des Hebels (355) zu bewegen.

4. Prüfplatine (115; 115') nach Anspruch 1 oder 2, wobei der Hauptkörper (305, 330) eine Aufliegebasis (305), die auf dem Substrat (205; 205') mittels der Montageeinrichtung (230, 245) montiert ist, und einen Schlitten (330) beinhaltet, der sich bezüglich der Basis entlang einer Richtung gleitend bewegt, die im Wesentlichen senkrecht zum Substrat ist, wobei die Kopplungseinrichtung (320, 365, 325, 370) ausgebildet ist, um den Hebel (355) zumindest rotatorisch mit dem Schlitten und rotatorisch-translatorisch mit der Basis zu koppeln.

5. Prüfplatine (115; 115') nach Anspruch 4, wobei die Kopplungseinrichtung (320, 365, 325, 370) ausgebildet ist, um den Hebel (355) rotatorisch-translatorisch mit dem Schlitten (330) zu koppeln, wobei die Kopplungseinrichtung (320, 365, 325, 370) eine erste Führung (320) und eine zweite Führung (325) auf der Basis (305), eine dritte Führung (345) auf dem Schlitten (330), eine erste Stifteinrichtung (365) und eine zweite Stifteinrichtung (370) an dem Hebel (355) beinhaltet, wobei sich die erste Stifteinrichtung entlang der ersten Führung gleitend bewegt, und sich die zweite Stifteinrichtung entlang der zweiten und der dritten Führung gleitend bewegt.

6. Prüfplatine (115; 115') nach Anspruch 5, wobei sich zumindest eine von der ersten Führung (320), der zweiten Führung (325) und der dritten Führung (345) entlang einer gekrümmten Linie erstreckt.

7. Prüfplatine (115; 115') nach einem der Ansprüche 1 bis 6, wobei die Umschalteinrichtung (350) eine Vorspanneinrichtung (350) beinhaltet, um das Drückelement (355) hin zur aktiven Position vorzuspannen, wobei das Drückelement ansprechend auf eine externe Betätigung entgegengesetzt zur Vorspanneinrichtung in die inaktive Position gebracht wird.

8. Prüfplatine (115; 115') nach einem der Ansprüche 1 bis 7, wobei jedes Verriegelungsbauteil (225) weiter eine Anschlageinrichtung (315) beinhaltet, um zu verhindern, dass das Drückelement (355) die Bank von Aufnahmeeinrichtungen (210; 210') bei Abwesenheit des elektronischen Bauteils (105; 105') erreicht.

9. Prüfplatine (115) nach einem der Ansprüche 1 bis 8, wobei jeder Anschluss (220) mit einem konvexen Kontaktgebiet endet, wobei jede Aufnahmeeinrichtung (250, 255) eine konkave Vertiefung beinhaltet, die mit dem konvexen Kontaktgebiet des entsprechenden Anschlusses zusammenpasst und aus einem elastischen Material besteht, das ausgebildet ist, um ansprechend auf einen Druck der elektronischen Bauteile (105) gegen die Prüfplatine (115) elastisch verformt zu werden.

10. Prüfplatine (115') nach einem der Ansprüche 1 bis 9, wobei jede Prüfplatine weiter eine Zentriereinrichtung (605) für jede Bank von Aufnahmeeinrichtungen (210') beinhaltet, wobei die Zentriereinrichtung ausgebildet ist, um auf das entsprechende elektronische Bauteil (105') einzuwirken, um jeden Anschluss (220') des elektronischen Bauteils mit der entsprechenden Aufnahmeeinrichtung (250', 255') zum Fluchten zu bringen.

11. Prüfgerät (100), das einen Satz von Prüfplatinen (115; 115') nach einem der Ansprüche 1 bis 10 sowie eine Einrichtung (130) beinhaltet, um die auf der Prüfplatine ruhenden elektronischen Bauteile (105; 105') zu prüfen.

12. Verfahren zur Herstellung einer Prüfplatine (115; 115') zum Prüfen elektronischer Bauteile (105; 105'), wobei jede eine Mehrzahl von Anschlüssen (220; 220') zum elektrischen Kontaktieren des elektronischen Bauteils aufweist, wobei das Herstellungsverfahren die Schritte beinhaltet:
Bereitstellen eines Trägersubstrates (205; 205'),
Anordnen eines Satzes von Bänken elektrisch leitender Aufnahmeeinrichtungen (210; 210') auf dem Substrat, wobei jede dazu vorgesehen ist, ein entsprechendes elektronisches Bauteil darauf ruhen zu lassen, und jede Aufnahmeeinrichtung (250, 255; 250', 255') ausgebildet ist, um einen Anschluss des entsprechenden elektronischen Bauteils aufzunehmen, und
Montieren einer Verriegelungseinrichtung (225) auf dem Substrat unabhängig von den Aufnahmeeinrichtungen, um die elektronischen Bauteile auf der Prüfplatine mechanisch zu verriegeln, wobei für jede Bank von Aufnahmeeinrichtungen die Verriegelungseinrichtung mindestens ein Verriegelungsbauteil (225) beinhaltet, um das elektronische Bauteil, das auf der Bank von Aufnahmeeinrichtungen ruht, gegen die Bank von Aufnahmeeinrichtungen zu drücken,
**dadurch gekennzeichnet, dass**
der Schritt des Montierens beinhaltet:
Montieren eines Hauptkörpers (305, 330) eines jeden Verriegelungsbauteils (225) auf dem Substrat (205; 205'), wobei das Verriegelungsbauteil weiter ein Drückelement (355), das mit dem Hauptkörper gekoppelt ist, und eine Umschalteinrichtung (350) beinhaltet, um das Drückelement zwischen einer aktiven Position, in welcher es das elektronische Bauteil (105; 105') gegen die Bank von Aufnahmeeinrichtungen (210; 210') drückt, und einer inaktiven Position umzuschalten, in welcher es nicht auf das elektronische Bauteil einwirkt.

13. Herstellungsverfahren nach Anspruch 12, das weiter die Schritte beinhaltet:
eine Bank von Inseln (525; 525') wird für jede Bank von Aufnahmeeinrichtungen auf dem Substrat (205; 205') erzeugt, wobei die Inseln aus einem elektrisch leitenden und verformbaren Material bestehen,
ein Formwerkzeug (530; 530'), das eine Mehrzahl von Formungselementen (535; 535') beinhaltet, die den Anschlüssen mindestens eines elektronischen Bauteils entsprechen, wird gegen die Inseln gedrückt, um die Inseln gemäß den Formungselementen zu verformen, und
Härten der Inseln, um die entsprechenden Aufnahmeeinrichtungen zu erhalten.

14. Herstellungsverfahren nach Anspruch 13, das weiter die Schritte beinhaltet:
Anordnen einer Begrenzungseinrichtung (545; 545') um jede Insel (525; 525') herum, um eine Verbreiterung der Insel während des Pressschrittes des Formwerkzeugs (530; 530') zu begrenzen.

15. Herstellungsverfahren nach Anspruch 13 oder 14, das weiter die Schritte beinhaltet:
mindestens eine Säule (725) aus weiterem verformbaren Material wird für jede Bank von Aufnahmeeinrichtungen auf dem Substrat (205') ausgebildet, wobei die mindestens eine Säule in einem inneren Abschnitt mittels einer Kante eines Hauptkörpers des Formungswerkzeugs (530'), entsprechend einem Gehäuse des mindestens einen elektronischen Bauteils, gepresst wird, und
die mindestens eine Säule wird gehärtet, um eine entsprechende Zentriereinrichtung zu erhalten, die ausgebildet ist, um auf das entsprechende elektronische Bauteil (105') einzuwirken, um jeden Anschluss (220') des elektronischen Bauteils mit der entsprechenden Aufnahmeeinrichtung (250', 255') zum Fluchten zu bringen.

## Revendications

1. Une carte de test (115 ; 115') pour le test de dispositifs électroniques (105, 105'), ayant chacun une pluralité de bornes (220, 220') pour la connexion électrique au dispositif, dans laquelle la carte de test comporte:
un substrat de support (205; 205');
un ensemble de batteries de réceptacles électriquement conducteurs (210, 210') disposés sur le substrat, chacun pour le soutien d'un dispositif électronique correspondant, chaque réceptacle (250, 255 ; 250', 255') étant adapté à la réception d'une borne du dispositif électronique correspondant;
des moyens de verrouillage (225) disposés sur le substrat pour le verrouillage mécanique des dispositifs électroniques, les moyens de verrouillage comportant pour chacune des batteries de réceptacles au moins un composant de verrouillage (225) pour venir presser le dispositif électronique soutenu par la batterie de réceptacles contre la batterie de réceptacles; et
des moyens d'assemblage (230; 245) pour assembler les moyens de verrouillage sur le substrat indépendamment du réceptacle;
**caractérisée en ce que**
chaque composant de verrouillage (225) comporte un corps principal (305; 330) assemblé sur le substrat (205, 205') au moyen des moyens d'assemblage (230-245), un élément poussoir (355) couplé au corps principal, et des moyens de commutation (350) pour la commutation de l'élément poussoir entre une position active dans laquelle il presse le dispositif électronique (105 ;105') contre la batterie de réceptacles (210; 210') et une position inactive dans laquelle il n'interfère pas avec le dispositif électronique.

2. La carte de test (115; 115') selon la revendication 1, dans laquelle l'élément poussoir (355) comporte un levier (355) se terminant avec une extrémité libre pour agir sur le dispositif électronique (105, 105'), et dans lequel le composant de verrouillage (225) comporte en outre des moyens de couplage (320, 365 ; 325, 370) pour le couplage du levier au corps principal (305, 330), les moyens de couplage (320, 365; 325, 370) étant adaptés à la mise en rotation du levier (355) autour d'un centre de rotation instantané, dans au moins une partie finale de la commutation vers la position active, le centre de rotation instantané et l'extrémité libre du levier étant substantiellement à une même distance du substrat (205 ; 205').

3. La carte de test (115 ; 115') selon la revendication 2, dans laquelle, au moins dans la partie finale de la commutation vers la position active, les moyens de couplage (320, 365, 325, 370) sont adaptés au déplacement du centre instantané de rotation vers l'extrémité libre du levier (355).

4. La carte de test (115 ; 115') selon la revendication 1 ou 2, dans laquelle le corps principal (305, 330) comporte une base de support (305) assemblée sur le substrat (205, 205') par les moyens d'assemblage (230-245) et un traîneau (330) relativement à la base le long d'une direction sensiblement perpendiculaire au substrat, les moyens de couplage (320, 365, 325, 370) étant adaptés au couplage du levier (355) au moins en rotation par rapport au traîneau et en translation-rotation par rapport à la base.

5. La carte de test (115; 115') selon la revendication 4, dans laquelle les moyens de couplage (320, 365, 325, 370) sont adaptés au couplage du levier (355) en rotation-translation relativement au traîneau (330), les moyens de couplage (320, 365, 325, 370) incluant un premier guide (320) et un second guide (325) sur la base (305), un troisième guide (345) sur le traîneau (330), une première (365) et une seconde tige (370) sur le levier (355), la première tige glissant le long du premier guide, et la seconde tige glissant le long du second et du troisième guide.

6. La carte de test (115 ; 115') selon la revendication 5, dans laquelle au moins l'un parmi le premier guide (320), le second guide (325) et le troisième guide (345) présente une ligne courbe.

7. La carte de test (115 ; 115') selon l'une quelconque des revendications 1 à 6, dans laquelle les moyens de commutation (350) comporte des moyens de prédisposition (350) pour prédisposer l'élément poussoir (355) vers la position active, l'élément poussoir étant rapporté à la position inactive en réponse à une commande externe contraire aux moyens de prédisposition.

8. La carte de test (115 ; 115') selon l'une quelconque des revendications 1 à 7, dans laquelle chaque composant de verrouillage (225) comporte en outre des moyens d'arrêt (315) pour empêcher l'élément poussoir (355) d'atteindre la batterie de réceptacles (210 ; 210') en l'absence d'un dispositif électronique.

9. La carte de test (115; 115') selon l'une quelconque des revendications 1 à 8, dans laquelle chaque borne (220) se termine par une région de contact convexe, chaque réceptacle (250; 255) incluant un évidemment concave correspondant à la région de contact convexe de la borne correspondante et étant réalisé au moyen d'un matériau élastique pouvant subir une déformation élastique en réponse à la pression exercée par les dispositifs électroniques (105) contre les cartes de test (115).

10. La carte de test (115 ; 115') selon l'une quelconque des revendications 1 à 9, dans laquelle chacune des cartes de test comporte en outre des moyens de centrage (605) pour chaque batterie de réceptacles (210'), les moyens de centrage étant adaptés à une interaction avec le dispositif électronique (105') pour l'alignement de chaque borne (220') du dispositif électronique avec le réceptacle correspondant (250'; 255').

11. Un appareil de test (100) comportant un ensemble de cartes de test (115; 115') selon l'une quelconque des revendications 1 à 10, et des moyens (130) pour tester les dispositifs électroniques (105; 105') disposés sur les cartes de test.

12. Un procédé de production d'une carte de test (115; 115') pour le test de dispositifs électroniques (105; 105'), ayant chacun une pluralité de bornes (220; 220') pour un contact électrique avec le dispositif, dans lequel le procédé de production comporte les étapes suivantes:
la mise à disposition d'un substrat de support (205; 205');
la mise à disposition sur le substrat d'une batterie de réceptacles électriquement conducteurs (210; 210'), chacun pour le soutien d'un dispositif électronique lui correspondant, chaque réceptacle (250, 255; 250', 255') étant adapté à la réception d'une borne du dispositif électronique correspondant; et
le montage de moyens de verrouillage (225) disposés sur le substrat et indépendants des réceptacles, pour assurer le verrouillage mécanique des dispositifs électroniques sur la carte de test, les moyens de verrouillage comportant pour chacune des batteries de réceptacles au moins un composant de verrouillage (225) pour venir presser le dispositif électronique soutenu par la batterie de réceptacles contre la batterie de réceptacles; et
**caractérisé en ce que** l'étape de montage comporte:
le montage sur le substrat (205 ; 205') d'un corps principal (305, 330) de chaque composant de verrouillage (225), le composant de verrouillage comportant en outre un élément poussoir (355) couplé au corps principal, et des moyens de commutation (350) pour la commutation de l'élément poussoir entre une position active dans laquelle il presse le dispositif électronique (105; 105') contre la batterie de réceptacles (210; 210') et une position inactive dans laquelle il n'interfère pas avec le dispositif électronique.

13. Le procédé de production selon la revendication 12, comportant en outre les étapes:
la réalisation d'une batterie d'îlots (525; 525') pour chaque batterie de réceptacles sur le substrat (205; 205'), les îlots étant réalisés au moyen d'un matériau déformable et électriquement conducteur ,
la mise sous presse par un outil de mise en forme (530; 530') comportant une pluralité d'éléments de mise en forme (535 ; 535') correspondant aux bornes d'au moins un dispositif électronique contre les îlots en vue d'une déformation des îlots suivant les éléments de mise en forme, et
le durcissement des îlots pour l'obtention des réceptacles correspondants.

14. Le procédé de production conformément à la revendication 13, comportant en outre les étapes :
disposition de moyens de contrainte (545 ; 545') autour de chaque îlot (525 ; 525') pour limiter un élargissement des îlots durant l'étape de mise sous presse par l'outil de mise en forme (530 ; 530').

15. Le procédé de production conformément aux revendications 13 ou 14, comportant en outre les étapes :
la formation d'au moins une colonne (725) d'un matériau supplémentaire déformable pour chaque batterie de réceptacles sur le substrat (205'), ladite colonne au moins étant pressée sur une partie intérieure par un bord du corps principal de l'outil de mise en forme (530') correspondant à un boîtier d'au moins un dispositif électronique, et
le durcissement de ladite colonne pour l'obtention de moyens de centrage correspondants étant adaptés à interférer avec le dispositif électronique correspondant (105') pour aligner chaque borne (220') du dispositif électronique avec le réceptacle correspondant (250 ; 255').
